(19) Europäisches Patentamt / European Patent Office / Office européen des brevets

(11) **EP 3 247 818 B1**

(12) **EUROPÄISCHE PATENTSCHRIFT**

(45) Veröffentlichungstag und Bekanntmachung des Hinweises auf die Patenterteilung:
**08.01.2025 Patentblatt 2025/02**

(21) Anmeldenummer: **16700882.0**

(22) Anmeldetag: **15.01.2016**

(51) Internationale Patentklassifikation (IPC):
**C23C 16/44** *(2006.01)* **C23C 14/54** *(2006.01)*

(52) Gemeinsame Patentklassifikation (CPC):
**C23C 16/4411; C23C 14/541**

(86) Internationale Anmeldenummer:
**PCT/EP2016/050840**

(87) Internationale Veröffentlichungsnummer:
**WO 2016/116383 (28.07.2016 Gazette 2016/30)**

(54) **BESCHICHTUNGSKAMMER ZUR DURCHFÜHRUNG EINES VAKUUM GESTÜTZTEN BESCHICHTUNGSVERFAHRENS, SOWIE BESCHICHTUNGSVERFAHREN**

COATING CHAMBER FOR IMPLEMENTING OF A VACUUM-ASSISTED COATING PROCESS, AND COATING PROCESS

CHAMBRE DE REVÊTEMENT POUR LA MISE EN OEUVRE D'UN PROCÉDÉ DE REVÊTEMENT PAR DÉPÔT SOUS VIDE ET PROCÉDÉ DE REVÊTEMENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.01.2015 US 201562104918 P**
**18.02.2015 US 201562117571 P**

(43) Veröffentlichungstag der Anmeldung:
**29.11.2017 Patentblatt 2017/48**

(73) Patentinhaber: **Oerlikon Surface Solutions AG, Pfäffikon**
**8808 Pfäffikon (CH)**

(72) Erfinder:
- **VETTER, Jörg**
  **51469 Bergisch Gladbach (DE)**
- **KRASSNITZER, Siegfried**
  **6800 Feldkirch (AT)**
- **ESSELBACH, Markus**
  **6800 Feldkirch (AT)**

(74) Vertreter: **IPS Irsch AG**
**Langfeldstrasse 88**
**8500 Frauenfeld (CH)**

(56) Entgegenhaltungen:
CN-A- 103 383 155 JP-A- 2015 000 994
US-A- 5 154 811 US-A- 6 046 439

**Beschreibung**

Die Erfindung betrifft eine Beschichtungskammer zur Durchführung eines Vakuum gestützten Beschichtungsverfahrens sowie ein Beschichtungsverfahren gemäss dem Oberbegriff der unabhängigen Ansprüche 1 und 13.

Vakuum gestützte Beschichtungsanlagen zur Beschichtung bzw. Veredelung von Oberflächen unterschiedlichster Teile aller Art wie Werkzeuge, Gehäuse für technische oder nicht technische Einrichtungen oder von anderen Teilen mit funktionellen Schichten, insbesondere mittels plasmagestützter PVD und CVD Verfahren, oft zum Aufbringen harter Schichten umfassend Nitride, Karbide, Boride, Oxide sowie deren Mischungen, DLC oder zum Aufbringen anderer Schichten müssen derart ausgelegt sein, dass sie bei niedrigen Kosten eine hohe Produktivität bei gleichzeitig möglichst großer Flexibilität der realisierbaren Prozesse hinsichtlich der sich einstellenden Teiletemperatur bei der industriellen Beschichtung erzielen können. Randbedingungen sind unter anderen vakuumtechnische Forderungen hinsichtlich der erforderlichen Pumpzeiten zur Erzielung eines hinreichend niedrigen Startdruckes in der Beschichtungskammer der Beschichtungsanlage, schnelle und zuverlässige Reinigung des Inneren der Beschichtungskammer von parasitären unvermeidlichen Beschichtungen, aber auch die Gewährleistung hinreichend hoher Beschichtungsraten bei einer gegebenen maximalen Teiletemperatur, die keinesfalls überschritten werden darf, sowie die Einstellung einer Mindesttemperatur, die nicht unterschritten werden sollte, muss während des Beschichtungsprozesses stets zuverlässig gewährleistet sein.

Die Beschichtungskammern werden im Stand der Technik für eine optimierte Kühlung oft doppelwandig ausgeführt oder aber auch einwandig mit Kühlelementen in kritischen ausgewählten Bereichen, z.B. in Form von Flanschen für Beschichtungsquellen. Die dem Fachmann bekannte Methode kurze Pumpzeiten zu realisieren sind dabei glatte Kammerwände, um die Desorptionsrate der unvermeidlichen Gasbelegung bei Kontakt mit der Raumluft bei offener Kammer zu minimieren. Eine erleichterte Reinigung wird standardmäßig mittels Wechselfolien, die auf der Kammerwand aufgebracht sind, und / oder mit auswechselbaren Blechen, die an die Kammerwand montiert werden, realisiert.

Nachteilig ist bei diesen aus dem Stand der Technik bekannten Anordnungen jedoch, dass die Auslegung der Beschichtungskammer hinsichtlich des flexiblen Einsatzes für verschiedene Temperaturbereiche bei hinreichend hohen Beschichtungsraten, insbesondere bei der Einhaltung einer minimalen bzw. maximalen Teiletemperatur konstruktionsbedingt sehr beschränkt ist. Ausserdem müssen die erwähnten Wechselfolien regelmässig ausgetauscht bzw. ersetzt werden, was zusätzliche Kosten verursacht.

Die Beschichtungsverfahren umfassen dabei meist auch Prozessschritte, die einen Wärmeeintrag in die Teile entweder gezielt, oder aber auch ungewollt prozessbedingt hervorrufen, was zum Beispiel zu einer Erhöhung der Substrattemperatur führen kann.

Prominente Bespiele für solche Prozessschritte sind unter anderem:
Beim Pumpen und Heizen der Substrate wird ein gezielter Wärmeeintrag durch Heizen, z.B. mittels Strahlungsheizer oder Elektronenheizung, bis zum Erreichen einer minimalen Startemperatur und eines hinreichend niedrigen Restgasdruckes generiert.

Bei der Ionenreinigung der Teileoberflächen kann dagegen ein an sich ungewollter Wärmeeintrag sozusagen als Nebenwirkung der Plasmaprozesse beispielsweise durch beschleunigte Ionen zum Ionenreinigen an den Substraten und Plasmaquellen, z.B. aber auch durch Wärmestrahlung oder Elektronenprozesse erfolgen.

Auch bei der eigentlichen Beschichtung der Substratoberflächen kommt es in der Regel zu einem nicht gewünschten Wärmeeintrag als Nebenwirkung der Plasmaprozesse (Beschichtungsmaterial) an den Substraten und Plasmaquellen (z.B. durch Wärmestrahlung, Elektronenprozesse).

Bei allen erwähnten drei relevanten Prozessschritten wird somit erwünscht oder unerwünscht Wärme in die Substrate eingetragen. In der Praxis sind die Substrate dabei meist auf rotierenden Substrathaltern innerhalb der Beschichtungskammer angeordnet, wobei die Substrathalter im Betriebszustand z.B. eine einfache, zweifache oder dreifache Rotation ausführen können um hinreichend homogene Beschichtungsresultate zu erzielen. Bedingt durch die niedrigen Prozessdrücke ist eine Wärmeabgabe im Wesentlichen nur durch Wärmestrahlung zwischen den Substraten und den kälteren Flächen, die während eines Prozessschrittes meist ausschließlich von der Kammerwand repräsentiert werden, möglich.

Dabei unterscheidet der Fachmann aus praktischen Gründen bei den gängigen Beschichtungsverfahren üblicherweise zwei Temperaturbereiche, die nachfolgend zur Erinnerung erwähnt und zur Klarstellung präzisiert werden.

**1. Niedrigtemperatur-Beschichtung (NTB): $T_{su} \leq 250$ °C**

Der industriell übliche Bereich der Niedrigtemperaturbeschichtung, abgekürzt NTB, liegt bei einer maximalen Teiletemperatur $T_{max}$ im Bereich von 150 °C bis 250 °C. Bei galvanisierten Kunststoffen als Substratmaterial sind jedoch bedeutend niedrigere Temperaturen erforderlich. Da dies einen Ausnahmefall darstellt, wird hier darauf nicht näher eingegangen und auf die entsprechende Literatur verwiesen.

Die Substratstarttemperaturen, abgekürzt $T_{su}$, dürfen, um eine zuverlässige Beschichtung zu gewährleisten bzw. um eine Schädigung der Substrate zu vermeiden, die maximale zulässige Teiletemperatur $T_{max}$,

die durch die zu beschichtenden Teilematerialien oder durch einzuhaltende Schichteigenschaften definiert ist, nicht oder höchstens kurzzeitig überschreiten. Die Prozesse werden allein schon aus Produktivitätsgründen derart geführt (Heizen, Ionenreinigung, Beschichtung), dass die Prozesszeit möglichst kurz ist, d.h. in der Nähe der zulässigen thermischen Belastung der Substrate bzw. der zulässigen Schichttemperatur liegt.

Bestimmend für Tmax können dabei verschiedene Prozesse oder Materialeigenschaften bzw. Vorgaben für die Qualität der Beschichtung sein. In der Regel führt beispielsweise eine hinreichend lange Überschreitung der maximalen Teiletemperatur Tmax zu einer negativen Beeinflussung des Substratwerkstoffes, z.B. Restaustenit-Umwandlung bei Kugellagerstählen, wodurch Maßveränderungen auftreten können, oder es kommt gar zu Abhärtungen (einsatzgehärtete Stähle).

Aber auch z.B. die zu erzielenden Schichteigenschaften können bestimmend für die Grenze Tmax sein. So ist es bekannt, dass sich bei bestimmten Schichten, z.B. DLC Schichten, insbesondere bei harten wasserstofffreien Kohlenstoffschichten des Typs ta-C, die Eigenschaften bei Überschreitung einer maximalen Temperatur negativ verändern. Z.B. können mehr $sp^2$ C-C-Bindungszustände gegenüber $sp^3$ C-C-Bindungszuständen ausgebildet werden.

## 2. Hochtemperatur-Beschichtung (HTB): Tmin ≤ 400 °C

Der industriell übliche Bereich der Hochtemperatur-Beschichtung, abgekürzt HTB, liegt üblicherweise bei einer minimalen Teiletemperatur, abgekürzt Tmin, im Bereich von 400 °C bis 600 °C. Die Substratstarttemperaturen Tsu dürfen die minimale geforderte Teiletemperatur Tmin bedingt durch die einzuhaltenden Schicht-Substrat-Systemeigenschaften nicht oder höchstens kurzzeitig unterschritten werden. Je nach Substratmaterial ist natürlich auch eine obere Temperaturgrenze einzuhalten.

Beispielsweise bei Stählen (z.B. sekundär gehärtete Stähle, HSS) wird meist eine minimale Teiletemperatur Tmin von 400°C bis zu 500 °C angestrebt. Für Hartmetalle werden üblicherweise auch Temperaturen bis zu 700°C realisiert.

Es versteht sich von selbst, dass in der Praxis auch Beschichtungsaufgaben anfallen, die im Temperaturbereich zwischen der NTB und HTB durchzuführen sind. Dies ist z.B. bei hartgelöteten Teilen der Fall. Auf diesen Zwischenbereich braucht jedoch hier nicht eigens eingegangen zu werden, da dieser Temperaturbereich zwischen NTB und HTB lediglich als ein Spezialfall der HTB zu verstehen ist.

Aus der US 6 046 439 A ist eine Beschichtungskammer bekannt, welche ein Wärmeschild umfasst, welches zwei Seiten mit unterschiedlichen Wärmeaustauschkoeffizienten hat und aus der JP2015-000994 eine Vakuumkammer mit einem Blech, welches mit Aluminiumoxid oder Nickel beschichtet ist.

Die aus dem Stand der Technik bekannten Beschichtungskammern sind dabei entweder so konstruiert, dass sie in der Praxis nur in einem vorgegebenen Temperaturbereich, z.B. in dem oben definierten NTB, HTB oder dazwischen mit befriedigenden Beschichtungergebnissen betreibbar sind. Oder aber ein Umbau der Beschichtungskammer unverhältnismässig aufwändig und damit insgesamt unwirtschaftlich ist. Durch die Beschränkung auf bestimmte Temperaturbereiche sind diese bekannten Beschichtungsanlagen gemäss den oben gegebenen Erläuterungen dann aber auch auf bestimmte Substratmaterialien bzw. Schichttypen, Schichtzusammensetzungen oder Eigenschaften der erzeugbaren Beschichtung beschränkt, was dazu führt, dass in ein und demselben Produktionsbetrieb oft mehrere unterschiedliche Beschichtungskammern für die verschiedenen Substrat- und Beschichtungstypen bereitgehalten werden müssen oder zumindest ein aufwändiger Umbau der Beschichtungskammern in Kauf genommen werden muss, wenn von einem Substrattyp bzw. von einen Beschichtungstyp auf einen anderen gewechselt werden muss.

Aufgabe der Erfindung ist es daher eine verbesserte Beschichtungskammer zur Verfügung zu stellen mit welcher die unterschiedlichsten Substrate und Beschichtungen bzw. Schichtsysteme in ein und derselben Beschichtungskammer unter unterschiedlichen Temperaturbedingungen herstellbar sind, wobei eine möglichst hohe Flexibilität der Beschichtungsanlagen hinsichtlich der Teiletemperatur bei möglichst geringen Prozesszeiten erzielt werden soll. Dabei soll es im Speziellen nicht nur mit sehr einfachen Massnahmen möglich sein die Beschichtungskammer an einen geforderten Temperaturbereich flexibel anzupassen. Es sollen zudem spezielle Ausführungsvarianten von Beschichtungskammern zur Verfügung gestellt werden, die im Vergleich zum Stand der Technik einen deutlich grösseren nutzbaren Temperaturbereich aufweisen, so dass in ein und derselben Beschichtungskammer eine grosse Zahl verschiedener Substrate bearbeitet werden kann bzw. eine grosse Zahl unterschiedlicher Beschichtungstypen herstellbar ist ohne aufwändige Umbauten beim Wechsel auf eine andere Beschichtungsaufgabe vornehmen zu müssen. Eine weitere Aufgabe der Erfindung ist es ein neues Beschichtungsverfahren zur Durchführung in einer erfindungsgemässen Beschichtungskammer bereitzustellen.

Der Erfindung liegt weiter die Aufgabe zugrunde, eine Lösung bereitzustellen, welche ermöglicht die Wärmeabfuhr in einer Beschichtungskammer derart zu regulieren, dass die Beschichtungstemperatur aufgrund einer Erhöhung der Wärmezufuhr nicht unkontrolliert steigt, sondern im gewünschten Arbeitspunkt gehalten werden kann.

Die diese Aufgaben lösenden Gegenstände der Erfindung sind durch die Merkmale der unabhängigen Ansprüche 1 und 13 gekennzeichnet.

Die jeweiligen abhängigen Ansprüche beziehen sich auf besonders vorteilhafte Ausführungsformen der Erfindung.

Die Erfindung betrifft somit eine Beschichtungskammer zur Durchführung eines Vakuum gestützten Beschichtungsverfahrens, insbesondere PVD- oder CVD oder Lichtbogenbeschichtungskammer oder Hybdrid-Beschichtungskammergemäss Anspruch 1.

Es sei an dieser Stelle darauf hingewiesen, dass dem Fachmann die physikalische Grösse, die im Rahmen dieser Anmeldung als "Wärmeaustauschkoeffizient" bezeichnet wird, auch z.B. unter den Begriffen "Emissionsgrad" oder "Emissionsverhältnis" geläufig ist und entsprechend den dem Fachmann bekannten Verfahren gemessen werden kann.

Zusätzlich kann der Wärmeschild einen Abschirmschild mit einer in Richtung zur Kammerwand gerichteten ersten Abschirmfläche und eine der Kammerwand abgewandte zweiten Abschirmfläche umfassen, wobei die erste Abschirmfläche und / oder die zweite Abschirmfläche jeweils eine glänzende reflektierende Oberfläche mit einem Bearbeitungszustand gemäss DIN EN10088 von mindestens 2D, bevorzugt einen Bearbeitungszustand gemäss DIN EN10088 von mindestens 2R hat.

Bevor weiter unten spezielle Ausführungsbeispiele der Erfindung im Detail diskutiert werden sollen im Folgenden zunächst die wesentlichen grundlegenden Merkmale der Erfindung diskutiert werden.

In der Praxis ist eine erfindungsgemässe Beschichtungskammer vorzugsweise eine doppelwandige Kammer, die zur Wärmeabfuhr alternativ mit kaltem oder warmem Wasser, unter bestimmten Umständen auch mit einem Öl oder einem anderen Temperierfluid betrieben werden kann. Wobei in speziellen Ausnahmefällen eine erfindungsgemässe Beschichtungskammer auch ohne Temperierung mit einem Temperierfluid wie Wasser oder Öl auskommen kann, z.B. dann, wenn prozessbedingt so wenig Wärme nach aussen abgeleitet werden muss, dass die Wärmeabgabe über die äusseren Flächen der Beschichtungskammer oder zusätzliche Wärmeableitelemente ausreichend ist.

Im Inneren der Kammer an den Kammerwänden sind Schildhalter vorgesehen, die bevorzugt im Wesentlichen geometrisch baugleiche aber thermisch unterschiedliche Schildkomponenten in Form von Einzelblechen als Einzellage oder als Blechstapel aufnehmen können und so den Wärmeschild bilden.

Es wird besonders bevorzugt mindestens ein Abstrahlschild für die Niedrigtemperaturbeschichtung (NTB) oder im Fall einer Hochtemperaturbeschichtung (HTB) ein modulares Blechpaket als Wärmeschild an die innere Kammerwand montiert, das zusätzlich mindestens einen Abschirmschild umfasst. Die wesentlichen Funktionsprinzipien des Abstrahlschildes und des Abschirmschildes können wie folgt zusammengefasst werden:

Der Abstrahlschild ist bevorzugt in Form eines Blechs an der inneren Kammerwand vorgesehen und ist insbesondere für Reinigungszwecke einfach demontierbar bzw. auswechselbar. Der Abstrahlschild erfüllt somit eine Doppelfunktion und dient einerseits als Schutz der Kammerwand gegenüber parasitären Beschichtungen und ermöglicht andererseits eine ausreichend starke Wärmeabgabe durch Strahlung an die Kammerwand durch Wärmestrahlung.

Im Speziellen kann die Kammerwand ebenfalls derart konditioniert sein, dass ein hinreichender Wärmeaustausch durch Wärmestrahlung zwischen dem Abstrahlschild und der Kammerwand ermöglicht wird. Besonders bevorzugt sind dabei die Strahlungseigenschaften, insbesondere die Wärmeaustauschkoeffizienten von Kammerwand und Abstrahlschild zum optimalen Wärmeaustausch aufeinander abgestimmt.

Aber auch dem Abschirmschild kommt eine Doppelfunktion zu. Auch der Abschirmschild ist in der Praxis häufig als ein an bzw. vor der Kammerwand vorgesehenes Blech ausgeführt, das ebenfalls einfach für Reinigungszwecke demontierbar ist. Somit bietet auch der Abschirmschild einerseits einen Schutz für die Kammerwand gegenüber parasitären Beschichtungen und ermöglicht andererseits im Gegensatz zum Abstrahlschild eine möglichst geringe Wärmeabgabe durch Wärmestrahlung in Richtung zur Kammerwand bzw. eines in Richtung zur bzw. vor der Kammerwand befindlichen weiteren Bleches eines Blechstapels durch Wärmestrahlung.

Die Kammerwand könnte dabei durchaus derart konditioniert sein, dass sich ein möglichst geringer Wärmeaustausch durch Wärmestrahlung zwischen dem ersten in Richtung der Kammer befindlichen Blechs des Blechstapels des Wärmeschilds und der Kammerwand einstellt. Dies ist jedoch mehr oder weniger unverträglich mit den Anforderungen der Niedrigtemperaturbeschichtung NTB, bei der ein Abstrahlschild eingesetzt werden soll. Also wird die Kammerwand in solchen Fällen bevorzugt derart konditioniert, dass sich eine maximale Wärmeabgabe durch Wärmestrahlung zur Kammerwand sich einstellt.

Nachfolgend sind einige Berechnungsbeispiele aufgeführt, um die dominierende Bedeutung der Beschichtung des Abstrahlschildes zu demonstrieren. Wie allgemein bekannt, ist der maximal mögliche Strahlungsaustauch beim schwarzen Strahler gegebenen, der einen Wärmeaustauschkoeffizienten von $\varepsilon_{Sch} = 1$ hat. Das bedeutet, wenn sowohl die Kammerwand als auch der Abstrahlschild einen Wärmeaustauschkoeffizienten von 1 aufweisen ist zwischen Abstrahlschild und Kammerwand der maximal mögliche Strahlungsaustausch gegeben. Die im Folgenden angegebenen Werte sind die in Messungen erreichten Bruchteile gegenüber dem Zustand des idealen schwarzen Strahlers. Die Berechnungsbeispiele belegen eindeutig die Notwendigkeit hoher Werte für den Wärmeaustauschkoeffizienten der beteiligten Strahlungsflächen Flächen im Falle der Niedrigtemperaturbeschichtung NTB.

Es liegen dabei die folgenden Annahmen zu Grunde:

A) Bester vakuumtechnischer Zustand der Oberflächen für niedrige Desorptionsraten. Die Kammerwand (Wärmeaustauschkoeffizient = $\varepsilon_k$) unnd das dieser direkt benachbarte Strahlungsblech (Wärmeaustauschkoeffizient = $\varepsilon_{Blech}$) sind aus rostfreiem Stahl und weitgehend Spiegelglanz poliert. Man erhält dann für die Wärmeaustauschkoeffizienten:

$$\varepsilon_k = \varepsilon_{Blech} : 0,1 +/- 0,05$$

und damit für den effektiven Gesamtaustauschkoeffizienten $\varepsilon_{ges} = 0,053$.
B) Häufig Fall in der industriellen Fertigung. Mattierte, verkratze Oberflächen der Kammerwand und direkt benachbartes Strahlungsblech aus rostfreiem Stahl, weitgehend glatt:

$$\varepsilon_k = \varepsilon_{Blech} : 0,2 +/- 0,1$$

und damit für den effektiven Gesamtaustauschkoeffizienten $\varepsilon_{ges} = 0,111$.
C) Strahlbehandlung zur Erzeugung rauer Oberflächen Kammerwand und direkt benachbartes Strahlungsblech aus rostfreiem Stahl, rau gestrahlt:

$$\varepsilon_k = \varepsilon_{Blech} : 0,4 +/- 0,1$$

und damit für den effektiven Gesamtaustauschkoeffizienten $\varepsilon_{ges} = 0,25$.
D) Kammerwand aus rostfreiem Stahl rau gestrahlt, direkt benachbartes Strahlungsblech aus rostfreiem Stahl rau gestrahlt und Beschichtung mit hohem Wärmeaustauschkoeffizient $\varepsilon_{Blech}$:

$$\varepsilon_k = 0,4 +/- 0,1$$

$\varepsilon_{Blech} = 0,85 +/- 0,15$ damit für den effektiven Gesamtaustauschkoeffizienten

$$\varepsilon_{ges} = 0,374.$$

E) Kammerwand aus rostfreiem Stahl rau gestrahlt und Beschichtung mit hohem Wärmeaustauschkoeffizient $\varepsilon_k$, direkt benachbartes Strahlungsblech aus rostfreiem Stahl rau gestrahlt und Beschichtung mit hohem Wärmeaustauschkoeffizient $\varepsilon_{Blech}$:

$$\varepsilon_k = 0,85 +/- 0,1$$

$\varepsilon_{Blech} = 0,85 +/- 0,15$ damit für den effektiven Gesamtaustauschkoeffizienten

$$\varepsilon_{ges} = 0,74.$$

F) Idealer schwarzer Strahler
$\varepsilon_k = \varepsilon_{Blech}$: 1 und damit für den effektiven Gesamtaustauschkoeffizienten

$$\varepsilon_{ges} = 1.$$

Natürlich hat auch die Kammertemperatur bzw. die Temperatur der Kammerwand ebenfalls einen Einfluss auf die Wärmeabgabe des Abstrahlschilds, da der Strahlungsaustauch bekanntermassen der vierten Potenz der Temperaturen folgt. Für die Niedrigtemperaturbeschichtung NTB sollte deshalb eine möglichst niedrige Wandtemperatur eingestellt werden, beispielsweise eine Kühlwassertemperatur einer doppelwandigen Beschichtungskammer von z.B. 20°C oder niedriger. Um diesen Einfluss zu demonstrieren, sei beispielsweise eine für NTB experimentell gemessene Temperatur eines Abstrahlschildes von 150 °C ausgewählt. Sind die Kammerwände nicht mit kalten Wasser gekühlt stellt sich im Betriebszustand eine Temperatur von oftmals 50°C oder gar mehr ein. Der Wärmefluss zur Kammerwand ist für eine Temperatur von 20°C rechnerisch um den Faktor 1,16 höher als der zur Kammerwand mit 50°C.
Dabei ist durch die Kammerkühlung zusätzlich ein weiterer die Teiletemperatur senkender Effekt erzielbar. Da die Kammerauskleidung mit Abstrahlschilden elektrisch nicht dicht zwischen dem Plasma und den Plasmaquellen ausgelegt ist, fließen oftmals Elektronen direkt zur geerdeten Kammerwand, wodurch deren Temperatur im Kammerinneren bei unzureichender Kühlung erhöht wird. Ein anderer Anteil der Elektronen kann direkt zur Erwärmung der Abstrahlschilde beitragen, auch wenn diese sich auf Kammerpotential befinden.
Somit können sowohl die Kammerwände als auch die Abstrahlschilde durch zwei unterschiedliche Anteile eines Gesamtwärmeeintrages erwärmt werden, wobei ein Anteil durch die Wärmestrahlung durch die sich auf Temperatur befindlichen zu beschichtenden Teile gegeben ist und der andere Anteil durch einen Elektronenfluss bestimmt sein, der dem Plasma und oder den Plasmaquellen entstammt. Die ist besonders stark ausgeprägt bei der Methode der kathodischen Vakuumbogenverdampfung, bei der oftmals in Summe beim Einsatz mehrerer Verdampfer mit Strömen von einigen 100A bis einigen 1000A gearbeitet wird. Auch bei optimierten Magnetfeldern zur Führung des Bogens und Anodenkonstruktionen rund um die Verdampfer fließen Elektronen zu den geerdeten Abstrahlschilden. Dieser Elektroneneffekt ist besonders stark ausgeprägt, wenn keine Anodenkonstruktionen um den Verdampfer konstruktiv vorgehen sind, sondern die Kammerwand die einzige Anode darstellt. Zur Verhinderung der Erwärmung ist es eine gute Lösung die Abstrahlschilde mittels eines Isolationselements elektrisch von der Kammerwand zu trennen, so dass die Elektronen zur gekühlten Kammerwand und nicht zu den Abstrahlschilden fließen.

Wie bereits dargelegt, ist es eine zentrale Erkenntnis der vorliegenden Erfindung, dass den Oberflächeneigenschaften des Abstrahlschildes, des Abschirmschildes und dem der Kammerwand eine zentrale Bedeutung zukommt. Damit ergibt sich erfindungsgemäss eine geeignete Konditionierung bzw. Beschichtung eines oder mehrerer der vorgenannten Komponenten.

Konstruktionsbedingt ist der erfindungsgemässe Abstrahlschild ein Abstrahlungs-Doppelfunktionsblech mit strahlungstechnisch zwei unterschiedlich ausgebildeten Seiten; die der Kammerwand zugewandte Seite und die Seite, die den zu beschichtenden Teilen zugewandt ist.

Die der Kammer zugewandte Seite wird in einem speziellen Ausführungsbeispiel der Erfindung mit geeigneten dem Fachmann bekannten Strahlmitteln (Korund, SiC und anderen), hinreichenden Strahldrücken, hinreichendem Einstrahlwinkel und Zeit einer Strahlbehandlung unterzogen, um so einen möglichst rauen (grau) wirkenden Oberflächenzustand zu erreichen. Die arithmetischen Mittelrauwerte (mittlere Rauheit), kurz $R_a$-Werte sollten Werte um $1\mu m$ $\pm0.2\mu m$ oder größer bis zu $10\mu m$ $\pm2\mu m$ aufweisen. Und Werte für die mittlere Rauheit, kurz $R_z$-Werte um $10\mu m$ $\pm2\mu m$ oder größer bis zu $100\mu m$ $\pm20\mu m$ betragen. Die der Kammer zugewandte Seite wird dann mit einer geeigneten möglichst schwarzen Schicht beschichtet, so dass haftfeste schwarze möglichst kratzfeste Schichten aufgebracht werden. Die Schichten können PVD-Schichten, z.B. $Al_x$-$Ti_y$N, vorzugsweise $Al_{66}Ti_{33}$N aber auch AlCrN, vorzugsweise mit der gleichen Zusammensetzung aber auch andere schwarze PVD-Schichten sein. Die Schichten werden optisch dicht abgeschieden. In der Regel reicht eine Schichtdicke von 500nm. Die Schichtdicken können aber auch dicker sein, z.B. im Bereich bis zu einigen um. Eine andere Variante ist die Beschichtung mit geeigneten DLC-Schichten, z.B. a-C, a-C:H, a-C.H:X, a-C:H:Me .

Die den zu beschichtenden Teilen zugewandte Seite wird ebenso wie die der Kammerwand zugewandte Seite durch eine Strahlbehandlung aufgeraut. Jedoch ist der Epsilonwert des Wärmeaustauschkoeffizienten über die Prozesszeit meist einer Änderung unterzogen, da je nach Beschichtungsverfahren und den auf den Teilen aufzubringenden Schichten unvermeidliche unterschiedliche Belegungen mit parasitärem Beschichtungen erfolgen. Im Idealfall für die Wärmeabgabe zur Kammerwand entstehen schwarze Schichten wie bei DLC-Beschichtungsverfahren in anderen Fällen jedoch auch metallisch graue Schichten wie bei der CrN-Beschichtung oder goldfarbene Schichten wie bei TiN-Beschichtungen mittels der kathodischen Vakuumbogenbeschichtung. Eine wesentliche Erkenntnis der Erfindung ist es jedoch, dass die raue Oberfläche unabhängig von den parasitären Belegungen den bestmöglichen Strahlungsaustausch zwischen den zu beschichtenden Teilen der kalten Kammerwand gewährleisten. Der Abstrahlschild wird nach jedem Zyklus oder beim zu starken Auftrag der parasitären Schichten einer erneuten Strahlbehandlung unterzogen. Die der Kammerwand zugewandte beschichtete Seite bedarf aus diesem Grunde einer möglichst abriebfesten Schicht, damit diese nicht während dieses Rekonditionierungsprozesses beschädigt wird. Gerade AlTiN-Schichten abgeschieden mittels der kathodischen Vakuumbogenverdampfung erfüllen diese Funktion in exzellenter Weise.

Eine geeignete Konditionierung bzw. Beschichtung der Kammerwand kann dabei beispielsweise wie folgt vorgenommen werden. Die Kammerwand wird mit geeigneten dem Fachmann bekannten Strahlmitteln (Korund, SiC und anderen) und hinreichenden Strahldrücken einer Strahlbehandlung unterzogen, um so einen möglichst rauen (grau) wirkenden Oberflächenzustand zu erreichen. Die $R_a$-Werte sollten Werte um $1\mu m$ $\pm0.2\mu m$ oder größer bis zu $10\mu m$ $\pm2\mu m$, $R_z$-Werte um $10\mu m$ $\pm2\mu m$ oder größer betragen, bis zu $100\mu m$ $\pm20\mu m$.

Eine Beschichtung der Kammerwand kann alternativ zusätzlich mit schwarzen Schichten durchgeführt werden. Diese sollten elektrisch leitfähig sein. Es kommen hier schwarze PVD-Schichten und leitfähige DLC-Schichten in Frage, wie sie schon für den in Form eines Abstrahlungs-Doppelfunktionsblechs ausgestalteten Abstrahlschild beschrieben wurden.

Im Folgenden noch einige wichtige Bemerkungen zu den Eigenschaften des Abschirmschilden. Bei dieser Art der Schilde handelt es sich in der Praxis praktisch immer um ein möglichst glattes Blech, im idealen Fall mit Spiegelglanz, um einen möglichst niedrigen Wärmefluss zu bedingen. Die der Kammer zugewandte Seite hat dabei eine glänzende reflektierende Oberfläche mit einem Bearbeitungszustand gemäss DIN EN10088 von mindestens 2D, bevorzugt einen Bearbeitungszustand gemäss DIN EN10088 von mindestens 2R, wobei Messungen der Rauheit unvermeidliche Kratzer ausschließen, die durch die Handhabung der Bleche entstehen bzw. Bereiche in denen sich Montageelemente befinden. Die den zu beschichtenden Teilen zugewandte Seite ist zwar in neuen Zustand ebenso glatt, aber je nach Beschichtungsverfahren und den auf den Teilen aufzubringenden Schichten wird die Oberfläche hinsichtlich Rauheit und Wärmeaustauschkoeffizient Epsilon unterschiedlich im Beschichtungsprozess verändert. Dennoch ist die eingestellte Rauheit derart, so dass der Wärmeübertrag zur Kammerwand minimiert wird.

Im Folgenden wird ein bevorzugtes Ausführungsbeispiel einer erfindungsgemässen Beschichtungskammer zur Durchführung eines Hochtemperatur Beschichtungsverfahrens HTB gemäss der Erfindung kurz skizziert. Um die Wärmeübertragung zur Kammerwand zu erniedrigen, die für die NTB möglichst hoch sein soll und durch die Verwendung des Abstrahlschildes, das in Richtung der Kammerwand beschichtet ist und mit der rauen Kammerwand wie beschrieben zusammenwirkt, für die HTB zu modifizieren wird mindestens ein geometrisch gleich oder sehr ähnlich ausgebildeter Abschirmungsschild zusätzlich montiert. Der Abstrahlschild wirkt dann wie ein Strahlungsschutzschirm. Vorzugsweise werden weitere Abschirmungsbleche zwischen dem Abstrahlschild und dem Abschirmschild vorgesehen. Wenn die Kammerwand doppelwandig ausgeführt ist, kann diese dann vorzugsweise mit warmen Wasser von ca. 50°C anstatt mit Kaltwasser gekühlt werden, um die Wärmeabstrahlung zur Kammer zu minimieren.

Bei einem besonders bevorzugten Ausführungsbeispiel werden drei gezogene Bleche aus rostfreiem Stahl (DIN 1.4301) mit 1 mm Dicke für den Wärmeschild in Form eines Blechsystems verwendet. Die Rauheit in Bereichen ohne unvermeidliche Kratzer lag im Bereich vom $R_a = 0{,}8 \mu m \pm 0.16 \mu m$ und $R_z = 6 \mu m \pm 1.2 \mu m$. Der Wärmeaustauschkoeffizient dieser Oberflächen wurde mit 0,15 +/-0,5 bestimmt. Die Strahlbehandlung eines Bleches, das für den Abstrahlschild eingesetzt wurde erfolgte mit einem Trockenstrahlprozess mit Korund. Die so eingestellte Rauheit war $R_a = 7 \mu m \pm 1.4 \mu m$ $R_z = 60 \mu m \pm 12 \mu m$. Dieser Abstrahlschild wurde dann mittels eines PVD-Prozesses, der kathodischen Vakuumbogenverdampfung, mit einer schwarzen AlTiN durch Einsatz von Kathoden der Zusammensetzung Al66Ti34 mit einer Schichtdicke von $1 \mu m$ beschichtet. Der Wärmeaustauschkoeffizient dieser Oberfläche wurde mit 0,83 +/- 0.5 gemessen. Die verwendete doppelwandige Beschichtungskammer wurde für den PVD-Prozess auf der Basis der kathodischen Vakuumbogenverdampfung im inneren der Kammer gestrahlt. Die mittlere Rauheit betrug $R_a = 5 \mu m \pm 1 \mu m$ und $R_z = 48 \mu m \pm 9.6 \mu m$. Es wurde für die HTB ein Wärmeschild in Form eines Blechsystems mit einem Abstrahlschild, einem darauf liegenden Abschirmblech und einem wiederum darauf liegenden Abschirmschild aufgebaut. Die für die HTB erforderlichen Temperaturen von 500°C wurden auch beim Einsatz einer Kühlwassertemperatur von 20°C erreicht.

Für die NTB bei ca. 200°C wurden sowohl der Abschirmschild als auch das Abschirmblech demontiert. Es befand sich also nur der einseitig beschichtete Abstrahlschild an der Kammerwand. Die Kühlwassertemperatur wurde bei 20°C belassen. Dadurch konnte ein kontinuierlicher Beschichtungsprozess mit den geforderten niedrigen Temperaturen ohne Prozessunterbrechung erfolgen.

Bei einem für die Praxis besonders bevorzugten Ausführungsbeispiel ist zur Einstellung des ersten vorgebbaren Wärmeaustauschkoeffizient oder des zweiten vorgebbaren Wärmeaustauschkoeffizient des Abstrahlschilds die erste Strahlungsfläche oder die zweite Strahlungsfläche rau ausgeführt, insbesondere ist eine Rauigkeit von $R_a = 1 \mu m \pm 0.2 \mu m$ bis $10 \mu m \pm 2 \mu m$ oder eine Rauigkeit von $R_z = 10 \mu m \pm 2 \mu m$ bis $100 \mu m \pm 20 \mu m$ vorgesehen, was sich wie bereits dargelegt als optimaler Parameter der Rauigkeit für die gewünschten Wärmeaustauchraten erwiesen hat.

Besonders vorteilhaft ist im Vergleich zum schwarzen Wärmeaustauschkoeffizient des schwarzen Strahlers mit $\varepsilon_{Sch} = 1.0$ die erste Strahlungsfläche eine schwarze Oberfläche oder alternativ oder gleichzeitig eine Oberflächenbeschichtung mit einem hohen ersten Wärmeaustauschkoeffizient im Bereich von 0.1 bis 1.0, im Speziellen zwischen 0.5 und 0.95, besonders bevorzugt zwischen 0.7 und 0.9, wobei der erste Wärmeaustauschkoeffizient besonders bevorzugt im Bereich von ca. 0.85 liegt.

Wie bereits vorher diskutiert umfasst die erste Strahlungsfläche und / oder die zweite Strahlungsfläche die erwähnte Oberflächenbeschichtung, die insbesondere eine mittels PVD abgeschiedene Beschichtung, im speziellen eine $Al_xTi_yN$, vorzugsweise $Al_{66}Ti_{33}N$ und / oder eine AlCrN, insbesondere eine $Al_{66}Cr_{33}N$ Beschichtung umfasst, und / oder eine geeignete DLC-Beschichtung, im Speziellen eine a-C, a-C:H, a-C.H:X, a-C:H:Me Beschichtung umfasst, wobei die Beschichtung bevorzugt eine optisch dicht abgeschiedene Beschichtung ist und / oder eine Schichtdicke von 100nm bis zu einigen 1000nm, im Speziellen zwischen 300nm bis 800nm und besonders bevorzugt mindestens 500nm hat.

Dabei kann insbesondere zur Verwendung für Niedrigtemperatur Beschichtungsverfahren im Bereich von bis zu einer maximalen Teiletemperatur von ca. 250°C der Wärmeschild auch nur genau einen und nur auf der ersten Strahlungsfläche beschichteten Abstrahlschild umfassen, so dass eine genügend hohe Wärmeübertragung von den sich im Inneren der Beschichtungskammer befindenden zu beschichteten Teile auf die Kammerwand gewährleistet ist.

Dagegen können insbesondere dann, wenn die Teile bei höheren Temperaturen, also z.B. im HTB Bereich oder bei Temperaturen zwischen dem NTB Bereich und dem HTB Bereich beschichtet werden sollen, zwischen dem der Kammerwand direkt benachbart angeordneten Abstrahlschild und dem Abschirmschild auch ein oder eine Mehrzahl weiterer Strahlungsschilde, im speziellen bis zu drei zusätzliche Strahlungsschilde zwischen dem Abstrahlschild und dem Abschirmschild vorgesehen sein.

Zur sicheren Montage an einem Schildhalter umfasst der Abstrahlschild und / oder der Abschirmschild und / oder der Strahlungsschild jeweils einen Montagebereich der so ausgestaltet ist, dass das entsprechende Strahlungsblech mit dem Montagebereich an einer Halteeinrichtung eines Schildhalters, bevorzugt alle Strahlungsbleche gleichzeitig mittels ein und desselben Schildhalters an der Kammerwand fixierbar sind. Die Strahlungsbleche können dabei zum Beispiel mit dem Schildhalter verschraubt sein, in einer Nute des Schildhalters verklemmt sein oder in anderer Weise bevorzugt lösbar mit dem Schildhalter verbunden sein.

Dabei sind der Abstrahlschild und / oder der Abschirmschild und / oder der Strahlungsschild zumindest im Montagebereich besonders vorteilhaft derart identisch geometrisch gestaltet, dass sie in jeder Halteeinrichtung des Schildhalters austauschbar verwendbar sind, so dass zwischen der Kammerwand und dem Wärmeschild unterschiedliche Charakteristiken des Wärmeaustauschs flexibel einstellbar sind. Einfach indem z.B. die Anordnung der Strahlungsbleche je nach Anforderungen geändert wird.

Dabei kann wie oben bereits erläutert der Abstrahlschild und / oder der Abschirmschild und / oder der Strahlungsschild elektrisch isoliert mit der Kammerwand verbunden sein, so dass eine zusätzliche Aufheizung durch freie Ladungsträger in der Beschichtungskammer, z.B. durch Elektronen oder Ionen zumindest signifikant reduziert wird, bzw. im Wesentlichen ganz vermieden wird.

Die Beschichtungskammer selbst hat dabei in der Praxis meist eine doppelwandig ausgestaltete Kammerwand, so dass innerhalb der doppelwandigen Kammerwand zu deren Temperierung ein Temperierfluid, meistens einfach vortemperiertes oder nicht vortemperiertes Wasser, ein Öl, oder ein anderes geeignetes Temperierfluid zirkulierbar ist.

Dabei kann auch die Innenseite der Kammerwand aufgeraut sein und zum Beispiel eine Rauheit im Bereich von $R_a = 1\,\mu m \pm 0.2\mu m$ bis $10\,\mu m \pm 2\mu m$ und / oder von $R_z = 10\,\mu m \pm 2\mu m$ bis $100\,\mu m \pm 20\mu m$ aufweisen. Dabei kann im Vergleich zum schwarzen Wärmeaustauschkoeffizient des schwarzen Strahlers mit $\varepsilon_{Sch} = 1.0$ die Innenseite eine schwarze Schicht mit einem hohen Kammeraustauschkoeffizienten im Bereich von 0.1 bis 1.0, im Speziellen zwischen 0.2 und 0.8, besonders bevorzugt zwischen 0.3 und 0.6, im Speziellen einen Kammeraustauschkoeffizient im Bereich von ca. 0.4 haben.

Und auch die Innenseite der Kammerwand kann analog zu den Strahlungsblechen eine Kammerbeschichtung aufweisen, die insbesondere eine mittels PVD abgeschiedene Beschichtung, im speziellen eine $Al_xTi_yN$, vorzugsweise $Al_{66}Ti_{33}N$ und / oder eine AlCrN, insbesondere eine $Al_{66}Cr_{33}N$ Beschichtung umfasst, und / oder eine geeignete DLC-Beschichtung, im Speziellen eine a-C, a-C:H, a-C.H:X, a-C:H:Me Beschichtung umfasst, wobei die Beschichtung bevorzugt eine optisch dicht abgeschiedene Beschichtung ist und / oder eine Schichtdicke von 100 nm bis zu einigen 1000 nm, im Speziellen zwischen 300 nm bis 800 nm und besonders bevorzugt mindestens 500nm hat.

Der Wärmeschild für eine Beschichtungskammer gemäss der vorliegenden Erfindung, ist insbesondere ein Nachrüstteil so dass auch eine bereits bestehende Beschichtungskammer mit einem Wärmeschild wie oben beschrieben nachgerüstet werden können.

Darüber hinaus betrifft die Erfindung auch ein Beschichtungsverfahren gemäss Anspruch 13 unter Verwendung einer Beschichtungskammer gemäss der beschriebenen Erfindung, wobei das Beschichtungsverfahren ein PVD-Verfahren, insbesondere ein PVD-Verfahren umfassend Magnetron-Sputtern und / oder HIPIMS, oder ein plasmagestütztes CVD Verfahren oder ein kathodisches oder ein anodisches Vakuumbogenverdampfungsverfahren oder ein aus diesen Verfahren gebildetes Kombinationsverfahren oder ein anderes Vakuum gestütztes Beschichtungsverfahren ist, wobei je nach verwendetem Beschichtungsverfahren oder je nach der konkret aufzubringenden Beschichtung zur Einstellung optimaler Beschichtungstemperaturen ein dafür optimal konfiguriertes Wärmeschild ausgewählt und verwendet wird.

Im Speziellen kann das Beschichtungsverfahren ein Niedrigtemperatur Beschichtungsverfahren sein und die Beschichtungskammer wird mit einem Temperierfluid, insbesondere Wasser oder Öl von einer Temperatur im Bereich von 10°C bis 30°C temperiert. Oder das erfindindungsgemässe Beschichtungsverfahren kann auch ein Hochtemperatur Beschichtungsverfahren sein, oder ein Beschichtungsverfahren, dass in einem Temperaturbereich zwischen einem NTB und einem HTB Verfahren durchgeführt wird, wobei die Beschichtungskammer mit dem Temperierfluid, insbesondere Wasser oder Öl von einer Temperatur im Bereich von 30°C bis 80°C, bevorzugt in einem Temperaturbereich von 40°C bis 60°C temperiert wird.

Die Erfindung wird im Folgenden an Hand der schematischen Zeichnung näher erläutert. Es zeigen:

Fig. 1    schematisch eine erfindungsgemässe Beschichtungskammer;

Fig. 2    eine Beschichtungskammer mit nur einem Abstrahlschild;

Fig. 3    eine Beschichtungskammer mit Abstrahlschild, Abschirmschild, und Strahlungsschild für den HTB Betrieb.

Fig. 4    eine schematische Darstellung der Anordnung von Grundelementen einer Vakuumkammer gemäss der vorliegenden Erfindung.

Fig. 5    den Verlauf der Temperatur von zu behandelnden Substraten, welche jeweils in einer nicht erfinderischen Vakuumkammer (gestrichelte Linie) und einer erfinderischen Vakuumkammer (durchgezogene Linie) behandelt wurden.

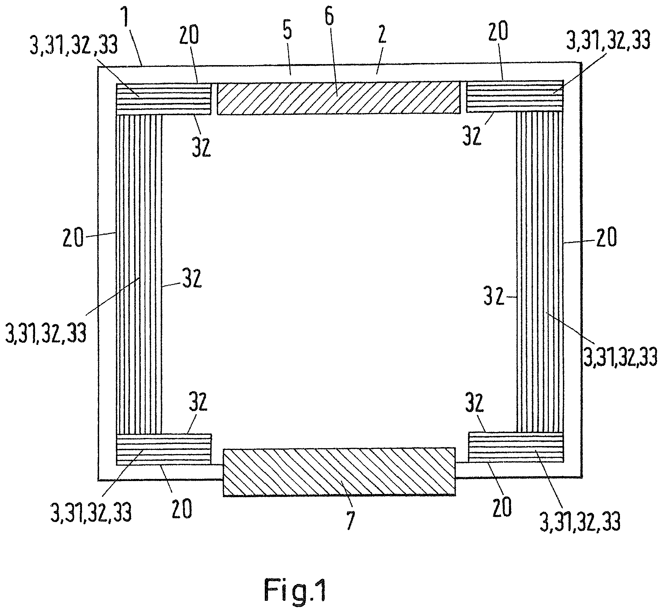

In Fig. 1 ist ein erstes einfaches Ausführungsbeispiel einer erfindungsgemässen Beschichtungskammer schematisch dargestellt, die z.B. zur Durchführung eines Hochtemperatur Beschichtungsverfahrens besonders vorteilhaft eingesetzt werden kann.

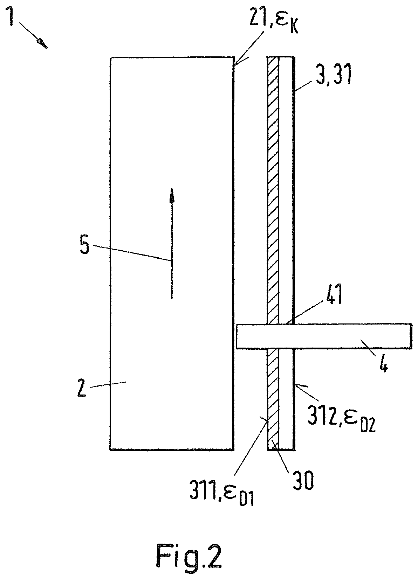

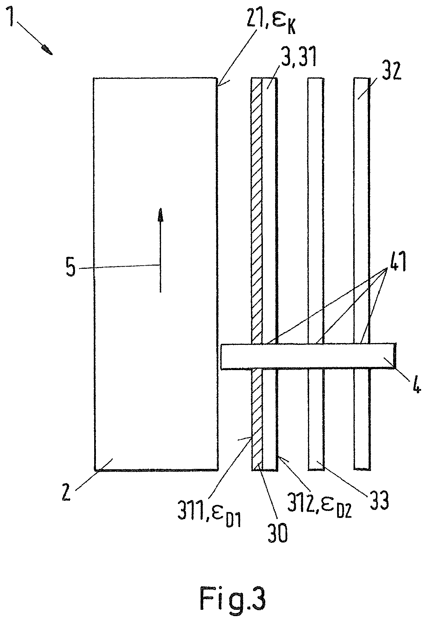

Die erfindungsgemässe Beschichtungskammer 1 zur Durchführung eines Vakuum gestützten Beschichtungsverfahrens gemäss Fig. 1 umfasst einen an einer temperierbaren Kammerwand 2 der Beschichtungskammer 1 angeordneten Wärmeschild 3, 31, 32, 33, der zur Einstellung eines Austausches einer vorgebbaren Menge an Wärmestrahlung zwischen dem Wärmeschild 3, 31, 32, 33 und der temperierbaren Kammerwand 2 dient. Gemäss der vorliegenden Erfindung umfasst der Wärmeschild 3, 31, 32, 33, einen einer Innenseite 21 der Kammerwand 2 direkt benachbarten austauschbaren Abstrahlschild 31, der eine in Richtung zur Kammerwand 2 gerichtete erste Strahlungsfläche 311 des Abstrahlschilds 31 mit einem ersten vorgebbaren Wärmeaustauschkoeffizient $\varepsilon_{D1}$ aufweist, wobei eine der Kammerwand 2 abgewandte zweite Strahlungsfläche 312 des Abstrahlschilds 31 einen zweiten vorgebbaren Wärmeaustauschkoeffizient $\varepsilon_{D2}$ aufweist, und der erste Wärmeaustauschkoeffizient $\varepsilon_{D1}$ grösser ist als der zweite Wärmeaustauschkoeffizient $\varepsilon_{D2}$. Aus Gründen der Übersichtlichkeit ist der Abstrahlschild 31 in Fig. 1 Nicht näher im Detail dargestellt. Der konkrete Aufbau des Abstrahlschild 31 ist jedoch im Wesentlichen identisch zu demjenigen aus Fig. 2a bzw. Fig. 3, so dass für Einzelheiten zum Aufbau des Abstrahlschilds 31 auf die Fig. 2a bzw. Fig. 3 verwiesen werden kann.

Die Beschichtungskammer 1 umfasst dabei in an sich bekannter Weise einen Heizer 6 zum Vorheizen der zu beschichtenden Teile, die sich im Betriebszustand z.B. auf einem rotierenden Teilehalter innerhalb der Beschichtungskammer 1 befinden und hier nicht dargestellt sind, sowie Plasmaquellen 7 für die Beschichtung, die an sich auch in vielen Variationen aus dem Stand der Technik bekannt sind. Details wie z.B. der Heizer, die Plasmaquellen, der Teilehalter für die zu beschichtenden Teile usw. sind dabei für das Verständnis der Erfindung an sich kaum von Bedeutung.

Zwischen dem der Kammerwand 2 direkt benachbarten Abstrahlschild 31 und dem Abschirmschild 32 ist eine Mehrzahl weiterer Strahlungsschilde 33 zwischen dem Abstrahlschild und dem Abschirmschild 32 vorgesehen.

Die Beschichtungskammer 1 selbst hat eine doppelwandig ausgestaltete Kammerwand 2, so dass innerhalb der doppelwandigen Kammerwand 2 zu deren Temperierung ein Temperierfluid 5, hier Wasser, zirkulierbar ist.

Die Innenseite 21 der Kammerwand 2 ist dabei entweder nur rau gestrahlt und / oder mit einer Kammerbeschichtung 20 versehen, die eine mittels PVD abgeschiedene Beschichtung ist, z.B. eine $Al_xTi_yN$, eine AlCrN Beschichtung oder eine geeignete DLC-Beschichtung, umfasst, wobei die Beschichtung eine optisch dicht abgeschiedene Beschichtung ist und eine Schichtdicke von 100 nm bis zu einigen 1000 nm hat.

Fig. 2a zeigt eine spezielle Beschichtungskammer mit nur einem Abstrahlschild 31 für den NTB Betrieb. Der Wärmeschild 3 besteht somit aus nur genau einem und nur auf der ersten Strahlungsfläche 311 beschichteten Abstrahlschild 31 zur Verwendung für Niedrigtemperaturbeschichtungen im Bereich von bis zu einer maximalen Teiletemperatur von ca. 250 °C.

Zur Einstellung des ersten vorgebbaren Wärmeaustauschkoeffizient $\varepsilon_{D1}$ und des zweiten vorgebbaren Wärmeaustauschkoeffizient $\varepsilon_{D2}$ des Abstrahlschilds 31 ist die erste Strahlungsfläche 311 und die zweite Strahlungsfläche 312 rau ausgeführt und hat eine Rauigkeit von $R_a$ =1 $\mu$m $\pm 0.2\mu$m bis 10 $\mu$m $\pm 2\mu$m bzw. eine Rauigkeit von $R_z$ = 10 $\mu$m $\pm 2\mu$m bis 100 $\mu$m $\pm 20\mu$m.

Ausserdem ist die erste Strahlungsfläche 311 mit einer Oberflächenbeschichtung 30 versehen, die im Vergleich zum schwarzen Wärmeaustauschkoeffizient $\varepsilon_{Sch}$ des schwarzen Strahlers mit $\varepsilon_{Sch}$ = 1.0 einen hohen ersten Wärmeaustauschkoeffizient $\varepsilon_{D1}$ im Bereich von 0.7 bis 0.9 hat.

Die Oberflächenbeschichtung 30 ist eine mittels PVD abgeschiedene Beschichtung, im speziellen eine $Al_xTi_yN$, eine AlCrN, oder eine geeignete DLC-Beschichtung, im Speziellen eine a-C, a-C:H, a-C.H:X, a-C:H:Me Beschichtung, wobei die Beschichtung eine optisch dicht abgeschiedene Beschichtung ist und eine Schichtdicke von 100 nm bis zu einigen 1000 nm hat, z.B. ca. 500nm dick ist.

Der Abstrahlschild 31 ist in einem Montagebereich an einer Halteeinrichtung 41 eines Schildhalters 4 mittels eines Schildhalters 4 an der Kammerwand 2 fixiert, wobei der Abstrahlschild 41 ein Abstrahlblech ist, das einfach in einer als Nute ausgestalteten Halteeinrichtung 41 des Schildhalters verklemmt eingesetzt ist, so dass es einfach und schnell ausgetauscht werden kann.

Anhand der Fig. 3 ist schliesslich ein spezielles Ausführungsbeispiel einer Beschichtungskammer 1 mit Abstrahlschild 31, Abschirmschild 32 und dazwischen angeordnetem Strahlungsschild 33. Diese Anordnung ist besonders für den Hochtemperatur Betrieb besonders gut geeignet.

In einer weiteren Ausgestaltung betrifft die vorliegende Erfindung eine Vakuumkammer und eine Beschichtungsanlage mit besonderer Gestaltung zur Erhöhung der Wärmeabführung.

Konventionelle Beschichtungsanlagen werden in der Regel so konzipiert, dass eine vorbestimmte Beschichtungstemperatur innerhalb der Beschichtungskammer bzw. des Rezipienten erreicht und gehalten werden kann. Häufig sind die Oberflächen im Innern der Beschichtungskammer aus glänzendem oder gestrahltem Edelstahl oder Aluminium. Da während der Durchführung von Beschichtungsprozessen die Inneren Wänden der Beschichtungskammer unerwünscht beschichtet werden können, wird in der Regel eine Abschirmung (Shielding) verwendet, um den Aufbau von dickeren Schichten auf die inneren Wänden zu vermeiden. Vor allem ist die Verwendung einer solchen Abschirmung sehr hilfreich, wenn mehrere Beschichtungsprozesse nacheinander ohne Wartung durchgeführt werden sollen und infolgedessen sich mehrere Schichten aufeinander kumulieren und es zu Abplatzungen während des Beschichtens und nach dem Beschichten kommt. Eine solche Abschirmung wird häufig auch aus glänzendem oder gestrahltem Edelstahl oder Aluminium hergestellt. Diese Gestaltung wird normalerweise gleichmässig im ganzen Rezipienten bzw. entlang der Mantelfläche, der Deckelfläche und der Bodenfläche angewendet.

Beschichtungsquellen, Heizungs- und Kühlelemente sind üblicherweise als einzelne Komponenten im Innern der Beschichtungskammer derart verteilt, dass einige innere Oberflächen bzw. innere Kammerwandflächen frei von Quellen und/oder Elementen bleiben. Infolgedessen wirken diese "freien" Oberflächen als Wärmeabfuhrelemente, bzw. in einer ähnlichen Weise wie Kühlelemente.

In der Regel spielt das Verhältnis zwischen Wärmezufuhr durch beispielweise Heizung und Beschichtungsquellen und Wärmeabfuhr durch die Mantelfläche der Beschichtungskammer eine entscheidende Rolle bei der Einstellung des Arbeitspunkts der Anlage hinsichtlich Beschichtungstemperatur, insbesondere wenn sowohl die Deckelfläche als auch die Bodenfläche der Beschichtungskammer thermisch isoliert sind. Deckelflächen und Bodenflächen thermisch zu isolieren führt zu einer homogenen Temperaturverteilung über die Beschichtungshöhe, auch wenn beispielsweise Heizungen ohne Temperaturregelung betrieben werden.

Bereits zum Starten eines Beschichtungsprozesses soll eine bestimmte Beschichtungstemperatur d.h. eine bestimmte Temperatur der zu beschichtenden Substratoberflächen erreicht werden. Für die Wärmezufuhr zumindest bis zum Starten des Beschichtungsprozesses werden häufig Heizelemente auf eine Kammerwandfläche angeordnet, so dass diese heissen Flächen Wärme auf das Substrat abstrahlen.

Nach dem Beginn und während der Durchführung des Beschichtungsprozesses wird durch den Betrieb der Beschichtungsquellen eine zusätzliche Wärmezufuhr hervorgebracht, welche besonders hoch sein kann wenn eine grosse Anzahl von Lichtbogenverdampfungsquellen mit hohen Lichtbogenströmen betrieben werden.

Würde man Substrate in einer Beschichtungsanlage mit einer bestimmten Beschichtung beschichten aber dabei eine erhöhte Beschichtungsrate erreichen wollen, könnte man es erreichen indem man beispielweise eine erhöhte Anzahl von Beschichtungsquellen verwendet. Jedoch muss man in diesem Fall mit einer dementsprechenden Erhöhung der Wärmezufuhr in die Beschichtungskammer rechnen, welche unmittelbar zu einer Erhöhung der Beschichtungstemperatur führt, wenn die Wärmeabfuhr nicht entsprechend angepasst bzw. erhöht wird. Diese Problematik ist besonders hoch wenn Lichtbogenverdampfungsquellen verwendet werden.

Der Erfindung liegt somit weiter die Aufgabe zugrunde, eine Lösung bereitzustellen, welche ermöglicht die Wärmeabfuhr in einer Beschichtungskammer derart zu regulieren, dass die Beschichtungstemperatur aufgrund einer Erhöhung der Wärmezufuhr nicht unkontrolliert steigt, sondern im gewünschten Arbeitspunkt gehalten werden kann.

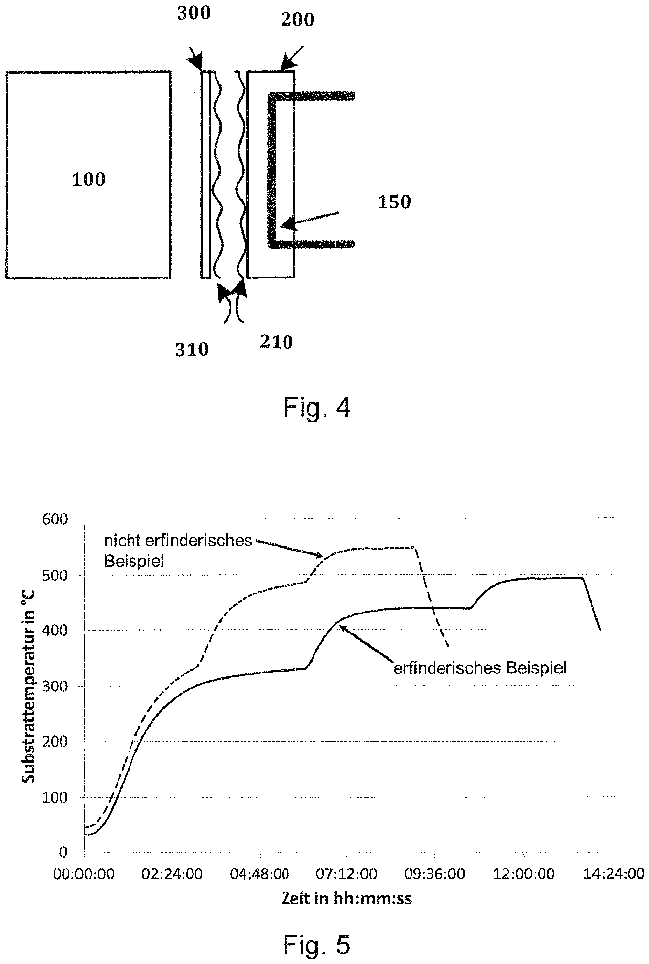

Um die zuvor erläuterten Sachverhalte vorliegende Erfindung besser zu verstehen, wird auf die Figuren 4 und 5 Bezug genommen:

-   Fig. 4 zeigt eine schematische Darstellung der Anordnung von Grundelementen einer Vakuumkammer gemäss der vorliegenden Erfindung.

-   Fig. 5 zeigt den Verlauf der Temperatur von zu behandelnden Substraten, welche jeweils in einer nicht erfinderischen Vakuumkammer (gestrichelte Linie) und einer erfinderischen Vakuumkammer (durchgezogene Linie) behandelt wurden.

Die vorliegende Erfindung offenbart grundsätzlich eine Vakuumkammer zur Behandlung von Substraten, welche mindestens folgende Elemente umfasst:

-   Wärmezuführungselemente zur Wärmezuführung in einen Behandlungsbereich der Vakuumkammer, in dem mindestens ein Substrat 100 behandelt werden kann,

-   eine Kammerwand 200, durch die Wärme aus dem Behandlungsbereich abgeführt werden kann, welche eine innere und eine äussere Kammerwandseite umfasst, und

-   eine Abschirmungswand 300, welche zwischen der Kammerwand 200 und dem Behandlungsbereich angeordnet ist, dergestalt dass eine hinsichtlich des Behandlungsbereichs abgewandten Abschirmungswandseite gegenüber der inneren Kammerwandseite gestellt ist,

und dadurch gekennzeichnet ist, dass

-   die gegenüber der inneren Kammerwandseite gestellte Abschirmungswandseite zumindest teilweise, vorzugsweise grösstenteils mit einer ersten Schicht 310 versehen ist, welche einen Emissionskoeffizient $\varepsilon \geq 0.65$ aufweist.

Gemäss einer bevorzugten Ausführungsform der vorliegenden Erfindung ist die innere Kammerwandseite auch zumindest teilweise, vorzugsweise zumindest grösstenteils mit einer zweiten Schicht 210 versehen, welche einen Emissionskoeffizient $\varepsilon \geq 0.65$ aufweist.

Gemäss einer weiteren bevorzugten Ausführungsform der vorliegenden Erfindung umfasst die Kammerwand 200 ein integriertes Kühlungssystem 150.

Vorzugsweise beträgt der Emissionskoeffizient der ersten Schicht 310 grösser gleich 0.80, noch bevorzugt grösser gleich 0.90.

Ebenfalls beträgt der Emissionskoeffizient der zweiten Schicht 210 vorzugsweise grösser gleich 0.80, noch bevorzugt grösser gleich 0.90.

Im Allgemeinen haben die Erfinder eine besonders bedeutende Erhöhung der Wärmeabfuhr ab $\varepsilon \geq 0.8$ festgestellt, insbesondere ab $\varepsilon \geq 0.9$. Noch bevorzugt ist ε nahe 1.

Gemäss noch einer bevorzugten Ausführungsform der vorliegenden Erfindung werden die erste Schicht 310 und/oder die zweite Schicht 210 zumindest teilweise mittels eines PVD-Verfahrens und/oder eines PACVD-Verfahrens abgeschieden (PVD: Physical Vapor Deposition; PACVD: Plasma assisted chemical vapor deposition).

Nach noch einer bevorzugten Ausführungsform der vorliegenden Erfindung umfasst die erste Schicht 310 und/oder die zweite Schicht 210 Aluminium und/oder Titan.

Ebenfalls vorzugsweise umfasst die erste Schicht 310 und/oder die zweite Schicht 210 Stickstoff und/oder Sauerstoff.

Die Erfinder haben auch festgestellt, dass Schichten, welche Titanaluminiumnitrid oder Aluminiumtitannitrid umfassen oder aus Titanaluminiumnitrid oder Aluminiumtitannitrid bestehen, sich als erste Schicht 310 und/oder zweite Schicht 210 im Kontext der vorliegenden Erfindung sehr gut eignen.

Auch Schichten, welche Aluminiumoxid umfassen oder aus Aluminiumoxid bestehen, können sich als erste Schicht 310 und/oder zweite Schicht 210 im Kontext der vorliegenden Erfindung gut eignen.

Die vorliegende Erfindung offenbart ebenfalls eine Beschichtungsanlage mit einer erfinderischen Vakuumkammer, wie oben beschrieben, als Beschichtungskammer.

Gemäss einer bevorzugten Ausführungsform einer erfinderischen Beschichtungsanlage, ist die Beschichtungskammer als eine PVD-Beschichtungskammer aufgebaut.

Vorzugsweise ist eine Abschirmungswand 300 zur Verminderung oder Vermeidung eines Beschichtens der inneren Kammerwandseite während der Durchführung eines PVD-Prozesses in der PVD-Beschichtungskammer vorgesehen.

Vorzugsweise werden sowohl Deckel- als auch Bodenflächen der PVD-Beschichtungskammer thermisch isoliert, um eine homogenere Temperaturverteilung über die gesamte Beschichtungshöhe (bzw. über die gesamte Höhe des Behandlungsbereichs) zu erreichen.

Vorzugsweise ist die Kammerwand 200 bzw. sind die Kammerwände 200 nicht mit funktionalen Elementen wie zum Beispiel Beschichtungs-, Plasmabehandlungs- oder Heizelementen versehen.

Je nach Bedarf können alle Kammerwände 200, an denen vorzugsweise keine solcher funktionalen Elemente angeordnet sind, mit einer zweiten Schicht 210 in der inneren Kammerwandseite versehen und mit einer Abschirmungswand 300 mit einer ersten Schicht 310 gemäss der vorliegenden Erfindung ausgestattet.

Ebenfalls kann von Vorteil sein, dass alle diese Kammerwände 200 mit integrierten Kühlungssystemen 150 ausgestattet werden, wenn eine noch erhöhte Wärmeabfuhr erreicht werden soll.

Wie bereits oben erwähnt, zeigt die Figur 2 den Vergleich des Verlaufes der Substrattemperatur in derselben Vakuumkammer, wobei einmal für das erfinderische Beispiel Abschirmungswände 300 und Kammerwände 200, wie oben beschrieben, erfindungsgemäss mit entsprechenden ersten Schichten 310 und zweiten Schichten 210 versehen wurden (durchgezogene Linie), und ein anderes Mal für das nicht erfinderische Beispiel die gleiche Vakuumkammeranordnung aber ohne Schichten 310 und 210 verwendet wurde (gestrichelte Linie). Beide Beispiele wurden bei gleicher Wärmezufuhr in die Beschichtungskammer durchgeführt.

Für das oben genannte erfinderische Beispiel wurde sowohl als erste Schicht 310 wie auch als zweite Schicht 210 eine PVD-abgeschiedene Titanaluminiumnitrid-Schicht mit einem Emissionskoeffizient ε von ca. 0.9 verwendet.

Gemäss einer bevorzugten Ausführungsform der vorliegenden Erfindung kann die innere Seite aller abgeschirmten Kammerwände mindestens grösstenteils mit einer entsprechenden zweiten Schicht 210 und die der Kammerwände gegenüberliegende Seite aller Abschirmungswände mindestens grösstenteils mit einer entsprechenden ersten Schicht 310 beschichtet werden.

Sowohl die Schicht 210 wie auch die Schicht 310 gemäss der vorliegenden Erfindung sollen aus Materialien bestehen, welche vakuumtauglich sind. Wichtig ist aber auch, dass diese Materialien nicht magnetisch sind, um Prozessstörungen beim Beschichten zu vermeiden.

Vorzugsweise weisen die Schichten 210 und/oder 310 zumindest eine der folgenden Eigenschaften auf:

- eine Schichtdicke nicht grösser als 50 μm,

- einen dichten Schichtaufbau, so dass womöglich kein Ausgasen durch die Schicht vorkommt,

- eine gute Haftung zum Trägermaterial damit guter Wärmeübergang gewährleistet werden kann,

- eine hohe Temperaturstabilität, welche erlaubt, dass Beschichtungsprozessen bei erhöhten Temperaturen, vorzugsweise bis mindestens 600°C durchgeführt werden können,

- gute Verschleißbeständigkeit, so dass diese Schichten in einem "rauen Produktionsumfeld" nicht schnell abgenutzt werden.

Vorzugsweise werden die Schichten 210 und/oder 310 mittels PVD-Techniken abgeschieden werden, so dass sie beispielsweise in derselben Beschichtungskammer auf die entsprechenden Kammerwand- und Abschirmungswandseiten aufgetragen werden können. In diesem Fall können beispielsweise zuerst die inneren Kammerwände in einem Beschichtungsprozess ohne Abschirmungswände mit der Schicht 210 beschichtet werden. Anschliessend können die Abschirmungswände in der Beschichtungskammer aber umgekehrt platziert werden, so dass die gewünschte Abschirmungswandseite, welche später sich gegenüber der inneren Kammerwandseite befindet wird, mit der Schicht 310 beschichtet werden kann. Es reicht ein einmaliges Auftragen der Schichten 210 und 310, um die Beschichtungsanlage mit einer erfindungsgemäss ausgestatteten Beschichtungskammer mehrmals zu betreiben.

Für die Durchführung eines PVD-Beschichtungsprozesses zum Beschichten von Substraten in einer erfindungsgemässen Beschichtungskammer werden die Abschirmungswände in der Beschichtungsanlage so angeordnet, dass die inneren Kammerwände bzw. die innere Seite der Kammerwänden abgeschirmt werden, um ein unerwünschtes Beschichten dieser Wänden zu minimieren bzw. zu vermeiden. Auf diese Weise wird grundsätzlich nur die Abschirmungswandseite ohne Schicht 310 während des Beschichtens von Substraten mitbeschichtet werden. Demzufolge bleiben sowohl die aufgetragene Schicht 310 wie auch die aufgetragene Schicht 210 nach jedem Beschichtungsprozess intakt.

Es versteht sich, dass die beschriebenen Ausführungsbeispiele lediglich exemplarisch zu verstehen sind und sich der Schutzbereich nicht auf die explizit beschriebenen Ausführungsformen beschränkt.

**Patentansprüche**

1. Beschichtungskammer zur Durchführung eines Vakuum gestützten Beschichtungsverfahrens, insbesondere PVD- oder CVD oder Lichtbogenbeschichtungskammer oder Hybdrid-Beschichtungskammer mit einem an einer temperierbaren Kammerwand (2) der Beschichtungskammer angeordneten Wärmeschild (3, 31, 32, 33) zur Einstellung eines Austausches einer vorgebbaren Menge an Wärmestrahlung zwischen dem Wärmeschild (3, 31, 32, 33) und der temperierbaren Kammerwand (2), **dadurch gekennzeichnet, dass** der Wärmeschild (3, 31, 32, 33) mindestens einen einer Innenseite (21) der Kammerwand (2) direkt benachbarten austauschbaren Abstrahlschild (31) umfasst, und eine in Richtung zur Kammerwand (2) gerichtete erste Strahlungsfläche (311) des Abstrahlschilds (31) einen ersten vorgebbaren Wärmeaustauschkoeffizient ($\varepsilon$D1) aufweist und eine der Kammerwand (2) abgewandte zweite Strahlungsfläche (312) des Abstrahlschilds (31) einen zweiten vorgebbaren Wärmeaustauschkoeffizient ($\varepsilon$D2) aufweist, wobei der erste Wärmeaustauschkoeffizient ($\varepsilon$D1) grösser ist als der zweite Wärmeaustauschkoeffizient ($\varepsilon$D2), wobei der Abstrahlschild (31) einen Montagebereich umfasst und im Montagebereich an einer Halteeinrichtung (41) eines Schildhalters (4) an der Kammerwand (2) fixierbar ist.

2. Beschichtungskammer nach Anspruch 1, wobei der Wärmeschild (3) mindestens einen Abschirmschild (32) umfasst, und eine in Richtung zur Kammerwand (2) gerichtete erste Abschirmfläche (321) des Abschirmschilds (32) und eine der Kammerwand (2) abgewandte zweite Abschirmfläche (322) des Abschirmschilds (32) jeweils eine glänzende reflektierende Oberfläche mit einem Bearbeitungszustand gemäss DIN EN10088 von mindestens 2D, bevorzugt einen Bearbeitungszustand gemäss DIN EN10088 von mindestens 2R aufweist.

3. Beschichtungskammer nach Anspruch 1 oder 2, wobei zur Einstellung des ersten vorgebbaren Wärmeaustauschkoeffizient ($\varepsilon$D1) und / oder des zweiten vorgebbaren Wärmeaustauschkoeffizient ($\varepsilon$D2) des Abstrahlschilds (31) die erste Strahlungsfläche (311) und / oder die zweite Strahlungsfläche (312) rau ausgeführt ist, insbesondere eine Rauigkeit von Ra =1 $\mu$m $\pm$0.2$\mu$m bis 10 $\mu$m $\pm$2$\mu$m und / oder eine Rauigkeit von Rz = 10 $\mu$m $\pm$2$\mu$m bis 100 $\mu$m $\pm$20$\mu$m aufweist.

4. Beschichtungskammer nach einem der vorangehenden Ansprüche, wobei im Vergleich zum schwarzen Wärmeaustauschkoeffizient ($\varepsilon$Sch) des schwarzen Strahlers mit $\varepsilon$Sch = 1.0 die erste Strahlungsfläche (311) eine schwarze Oberfläche und / oder eine Oberflächenbeschichtung (30) mit einem hohen ersten Wärmeaustauschkoeffizient ($\varepsilon$D1) im Bereich von 0.1 bis 1.0, im speziellen zwischen 0.5 und 0.95, besonders bevorzugt zwischen 0.7 und 0.9, im Speziellen einen ersten Wärmeaustauschkoeffizient ($\varepsilon$D1) im Bereich von ca. 0.85 hat.

5. Beschichtungskammer nach einem der vorangehenden Ansprüche, wobei die erste Strahlungsfläche (311) und / oder die zweite Strahlungsfläche (312) die Oberflächenbeschichtung (30) umfasst, und die Oberflächenbeschichtung (30) insbesondere eine mittels PVD abgeschiedene Beschichtung, im speziellen eine AlxTiyN, vorzugsweise Al66Ti33N und / oder eine AlCrN, insbesondere eine Al66Cr33N Beschichtung umfasst, und / oder eine geeignete DLC-Beschichtung, im Speziellen eine a-C, a-C:H, a-C.H:X, a-C:H:Me Beschichtung umfasst, wobei die Beschichtung bevorzugt eine optisch dicht abgeschiedene Beschichtung ist und / oder eine Schichtdicke von 100 nm bis zu einigen 1000 nm, im Speziellen zwischen 300 nm bis 800 nm und besonders bevorzugt mindestens 500nm hat.

6. Beschichtungskammer nach Anspruch 5, wobei der Wärmeschild (3, 31, 32, 33) nur genau einen und nur auf der ersten Strahlungsfläche (311) beschichteten Abstrahlschild (31), insbesondere zur Verwendung für Niedrigtemperaturbeschichtungen im Bereich von bis zu einer maximalen Teiletemperatur von 250 °C umfasst.

7. Beschichtungskammer nach einem der vorangehenden Ansprüche, wobei zwischen dem der Kammerwand (2) direkt benachbarten Abstrahlschild (31) und dem Abschirmschild (32), bevorzugt ein oder eine Mehrzahl weiterer Strahlungsschilde (33), im speziellen bis zu drei Strahlungsschilde (33) zwischen dem Abstrahlschild (31) und dem Abschirmschild (32) vorgesehen sind.

8. Beschichtungskammer nach einem der vorangehenden Ansprüche, wobei der Abstrahlschild (31) und / oder der Abschirmschild (32) und / oder der Strahlungsschild (33) jeweils einen Montagebereich umfasst und im Montagebereich an einer Halteeinrichtung (41) eines Schildhalters (4), bevorzugt mittels ein und desselben Schildhalters (4) an der Kammerwand (2) fixiert sind.

9. Beschichtungskammer nach einem der vorangehenden Ansprüche, wobei der Abstrahlschild (31) und / oder der Abschirmschild (32) und / oder der Strahlungsschild (33) zumindest im Montagebereich derart identisch geometrisch gestaltet sind, dass sie in jeder Halteeinrichtung (41) des Schildhalters (4) austauschbar verwendbar sind, so dass zwischen der Kammerwand (2) und dem Wärmeschild (3, 31, 32, 33) unterschiedliche Charakteristiken des Wärmeaustauschs flexibel einstellbar sind und / oder wobei der Abstrahlschild (31) und / oder der Abschirmschild (32) und / oder der Strahlungsschild (33) elektrisch isoliert mit der Kammerwand (2) verbunden ist.

10. Beschichtungskammer nach einem der vorangehenden Ansprüche, wobei die Beschichtungskammer eine doppelwandig ausgestaltete Kammerwand (2) umfasst, so dass innerhalb der doppelwandigen Kammerwand (2) zu deren Temperierung ein Temperierfluid (5), insbesondere Wasser oder ein Öl zirkulierbar ist.

11. Beschichtungskammer nach einem der vorangehenden Ansprüche, wobei die Innenseite (21) der Kammerwand (2) eine Rauheit im Bereich Ra = 1 $\mu$m $\pm 0.2 \mu$m bis 10 $\mu$m $\pm 2 \mu$m und / oder von Rz = 10 $\mu$m $\pm 2 \mu$m bis 100 $\mu$m $\pm 20 \mu$m aufweist und / oder wobei im Vergleich zum schwarzen Wärmeaustauschkoeffizient des schwarzen Strahlers mit $\varepsilon$Sch = 1.0 die Innenseite (21) eine schwarze Schicht mit einem hohen Kammeraustauschkoeffizient ($\varepsilon$K) im Bereich von 0.1 bis 1.0, im Speziellen zwischen 0.2 und 0.8, besonders bevorzugt zwischen 0.3 und 0.6, im Speziellen einen Kammeraustauschkoeffizient ($\varepsilon$K) im Bereich von ca. 0.4 hat.

12. Beschichtungskammer nach einem der vorangehenden Ansprüche, wobei die Innenseite (21) der Kammerwand (2) eine Kammerbeschichtung umfasst, und die Kammerbeschichtung (20) insbesondere eine mittels PVD abgeschiedene Beschichtung, im speziellen eine AlxTiyN, vorzugsweise Al66Ti33N und / oder eine AlCrN, insbesondere eine Al66Cr33N Beschichtung umfasst, und / oder eine geeignete DLC-Beschichtung, im Speziellen eine a-C, a-C:H, a-C.H:X, a-C:H:Me Kammerbeschichtung (20) umfasst, wobei die Kammerbeschichtung (20) bevorzugt eine optisch dicht abgeschiedene Beschichtung ist und / oder eine Schichtdicke von 100 nm bis zu einigen 1000 nm, im Speziellen zwischen 300 nm bis 800 nm und besonders bevorzugt mindestens 500nm hat.

13. Beschichtungsverfahren unter Verwendung einer Beschichtungskammer (1) nach einem der Ansprüche 1 bis 12, wobei das Beschichtungsverfahren ein PVD-Verfahren, insbesondere ein PVD-Verfahren umfassend Magnetron-Sputtern und / oder HIPIMS, oder ein plasmagestütztes CVD Verfahren oder ein kathodisches oder ein anodisches Vakuumbogenverdampfungsverfahren oder ein aus diesen Verfahren gebildetes Kombinationsverfahren oder ein anderes Vakuum gestütztes Beschichtungsverfahren ist.

14. Beschichtungsverfahren nach Anspruch 13, wobei das Beschichtungsverfahren ein Niedrigtemperatur Beschichtungsverfahren ist und die Beschichtungskammer (2) mit einem Temperierfluid (5), insbesondere Wasser oder Öl von einer Temperatur im Bereich von 10°C bis 30°C temperiert wird, oder wobei das Beschichtungsverfahren ein Hochtemperatur Beschichtungsverfahren ist und die Beschichtungskammer (2) mit dem Temperierfluid, insbesondere Wasser oder Öl von einer Temperatur im Bereich von 40°C bis 60°C temperiert wird.

**Claims**

1. Coating chamber for performing a vacuum-assisted coating process, in particular PVD or CVD or arc coating chamber or a hybrid coating chamber with a heat shield (3, 31, 32, 33), which is arranged on a temperature-controllable chamber wall (2) of the coating chamber and is intended for adjusting an exchange of a predeterminable amount of thermal radiation between the heat shield (3, 31, 32, 33) and the temperature-controllable chamber wall (2), **characterized in that** the heat shield (3, 31, 32, 33) comprises at least one exchangeable radiating shield (31), which is directly adjacent to an inner side (21) of the chamber wall (2), and a first radiation surface (311) of the radiating shield (31), that is directed towards the chamber wall (2), has a first predetermi-

nable heat exchange coefficient ($\varepsilon_{D1}$) and a second radiation surface (312) of the radiating shield (31) being directed away from the chamber wall (2) has a second predeterminable heat exchange coefficient ($\varepsilon_{D2}$), wherein the first heat exchange coefficient ($\varepsilon_{D1}$) is greater than the second heat exchange coefficient ($\varepsilon_{D2}$), wherein the radiating shield (31) comprises an assembly area and can be fixed to a holding device (41) of a shield holder (4) at the chamber wall (2) in the assembly area.

2. Coating chamber according to claim 1, wherein the heat shield (3) comprises at least one protection shield (32), and a first protection surface (321) of the protection shield (32), that is directed towards the chamber wall (2) and a second protection surface (322) of the protection shield (32), that is directed away from the chamber wall (2), each having a shiny reflecting surface with a processing status according to DIN EN10088 of at least 2D, preferred a processing status according to DIN EN10088 of at least 2R.

3. Coating chamber according to claim 1 or 2, wherein the first radiation surface (311) and / or the second radiation surface (312) for adjusting the first predeterminable heat exchange coefficient ($\varepsilon_{D1}$) and / or the second predeterminable heat exchange coefficient ($\varepsilon_{D2}$) of the radiating shield (31) is rough, in particular having a roughness of $R_a = 1\ \mu m \pm 0.2\ \mu m$ to $10\ \mu m \pm 2\mu m$ and / or a roughness of $R_z = 10\ \mu m \pm 2\mu m$ to $100\ \mu m \pm 20\mu m$.

4. Coating chamber according to one of the preceding claims, wherein the first radiation surface (311) has a black surface and / or a surface coating (30) with a high first heat exchange coefficient ($\varepsilon_{D1}$) in the range of 0.1 to 1.0, especially between 0.5 and 0.95, in particular preferred between 0.7 and 0.9, especially a first heat exchange coefficient ($\varepsilon_{D1}$) in the range of approximately 0.85, compared to the black heat exchange coefficient ($\varepsilon_{Sch}$) of the black radiator with $\varepsilon_{Sch} = 1.0$.

5. Coating chamber according to one of the preceding claims, wherein the first radiation surface (311) and / or the second radiation surface (312) comprises the surface coating (30), and the surface coating (30) comprising a coating, in particular deposited by means of PVD, especially an $Al_xTi_yN$, preferred $Al_{66}Ti_{33}N$ and / or an AlCrN, in particular a $Al_{66}Cr_{33}N$ coating, and / or comprising a suitable DLC-coating, especially an a-C, a-C:H, a-C.H:X, a-C:H:Me coating, wherein the coating is preferred an optically dense deposited coating and / or has a coating thickness of 100 nm to a few 1000 nm, especially between 300 nm to 800 nm and in particular preferred at least 500 nm.

6. Coating chamber according to claim 5, wherein the heat shield (3, 31, 32, 33) comprises exactly only one radiating shield (31) being coated only on the first radiation surface (311), in particular for applying for low temperature coatings in the range of up to a maximum temperature of parts of 250°C.

7. Coating chamber according to one of the preceding claims, wherein preferably one or a majority of additional radiation shields (33) are provided between the radiating shield (31), which is directly adjacent to the chamber wall (2), and the protection shield (32), especially up to three radiation shields (33) between the radiating shield (31) and the protection shield (32) are provided.

8. Coating chamber according to one of the preceding claims, wherein the radiating shield (31) and / or the protection shield (32) and / or the radiation shield (33) each comprising an assembly area and being fixed to a holding device (41) of a shield holder (4) at the chamber wall (2) in the assembly area, preferred by means of one and the same shield holder (4).

9. Coating chamber according to one of the preceding claims, wherein the radiating shield (31) and / or the protection shield (32) and / or the radiation shield (33) is geometrically designed at least in the assembly area in such an identically manner, that they can be applied interchangeably in each holding device (41) of the shield holder (4), so that different characteristics of the heat exchange can be adjusted flexibly between the chamber wall (2) and the heat shield (3, 31, 32, 33) and / or wherein the radiating shield (31) and / or the protection shield (32) and / or the radiation shield (33) is connected electrically insulated with the chamber wall (2).

10. Coating chamber according to one of the preceding claims, wherein the coating chamber comprises a double-walled designed chamber wall (2), so that a thermostating fluid (5), especially water or an oil, is circulable inside the double-walled chamber wall (2) for thermostating.

11. Coating chamber according to one of the preceding claims, wherein the inner side (21) of the chamber wall (2) has a roughness in the range of $R_a = 1\ \mu m \pm 0.2\ \mu m$ to $10\ \mu m \pm 2\mu m$ and / or of $R_z = 10\ \mu m \pm 2\mu m$ to $100\ \mu m \pm 20\mu m$ and / or wherein the inner side (21) has a black coating with a high chamber exchange coeffizient ($\varepsilon_K$) in the range of 0.1 to 1.0, especially between 0.2 and 0.8, in particular preferred between 0.3 and 0.6, especially a chamber exchange coefficient ($\varepsilon_K$) in the range of approximately 0.4, compared to the black heat exchange coefficient of the black radiator with $\varepsilon_{Sch} = 1.0$.

12. Coating chamber according to one of the preceding claims, wherein the inner side (21) of the chamber wall (2) comprises a chamber coating, and the chamber coating (20) comprising a coating, in particular deposited by means of PVD, especially an $Al_xTi_yN$, preferred $Al_{66}Ti_{33}N$ and / or an AlCrN, in particular an $Al_{66}Cr_{33}N$ coating, and / or comprising a suitable DLC-coating, especially an a-C, a-C:H, a-C.H:X, a-C:H:Me chamber coating (20), wherein the chamber coating (20) is preferred an optically dense deposited coating and / or has a coating thickness of 100 nm to a few 1000 nm, especially between 300 nm to 800 nm and in particular preferred at least 500 nm.

13. Coating process using a coating chamber (1) according to one of the claims 1 to 12, wherein the coating process is a PVD process, in particular a PVD process comprising magnetron sputtering and / or HIPIMS, or a plasma-assisted CVD process or a cathodic or an anodic vacuum arc vaporization process or a combination process formed of these processes or another vacuum-assisted coating process.

14. Coating process according to claim 13, wherein the coating process is a low temperature coating process and the coating chamber (2) is thermostated by a thermostating fluid (5), especially water or oil, from a temperature in the range of 10°C to 30°C, and wherein the coating process is a high temperature coating process and the coating chamber (2) is thermostated with the thermostating fluid, in particular water or oil with a temperature in the range of 40°C to 60°C.

**Revendications**

1. Chambre de revêtement pour la mise en oeuvre d'un procédé de revêtement assisté par vide, en particulier chambre de revêtement PVD ou CVD ou chambre de revêtement à arc électrique ou chambre de revêtement hybride, avec un bouclier thermique (3, 31, 32, 33) disposé sur une paroi de chambre (2) pouvant être tempérée de la chambre de revêtement pour le réglage d'un échange d'une quantité prédéfinissable de rayonnement thermique entre le bouclier thermique (3, 31, 32, 33) et la paroi de chambre (2) pouvant être tempérée **caractérisée en ce que** le bouclier thermique (3, 31, 32, 33) comprend au moins un bouclier de rayonnement (31) échangeable directement adjacent à un côté intérieur (21) de la paroi de chambre (2), et une première surface de rayonnement (311) du bouclier de rayonnement (31) orientée en direction de la paroi de chambre (2) présente un premier coefficient d'échange thermique prédéfinissable (εD1) et une deuxième surface de rayonnement (312) du bouclier de rayonnement (31) opposée à la paroi de chambre (2) présente un deuxième coefficient d'échange thermique prédéfinissable (εD2), le premier coefficient d'échange thermique (εD1) étant supérieur au deuxième coefficient d'échange thermique (εD2), le bouclier de rayonnement (31) comprenant une zone de montage et pouvant être fixé dans la zone de montage sur un dispositif de maintien (41) d'un support de bouclier (4) sur la paroi de chambre (2).

2. Chambre de revêtement selon la revendication 1, le bouclier thermique (3) comprenant au moins un bouclier de protection (32), et une première surface de protection (321) du bouclier de protection (32) orientée en direction de la paroi de chambre (2) et une deuxième surface de protection (322) du bouclier de protection (32) opposée à la paroi de chambre (2) présentant respectivement une surface réfléchissante brillante avec un état d'usinage selon DIN EN10088 d'au moins 2D, de préférence un état d'usinage selon DIN EN10088 d'au moins 2R.

3. Chambre de revêtement selon la revendication 1 ou 2, la première surface de rayonnement (311) et/ou la deuxième surface de rayonnement (312) étant réalisée rugueuse pour le réglage du premier coefficient d'échange thermique prédéfinissable (εD1) et/ou du deuxième coefficient d'échange thermique prédéfinissable (εD2) du bouclier de rayonnement (31), en particulier présentant une rugosité de Ra = 1 μm ± 0.2 μm à 10 μm ± 2 μm et/ou une rugosité de Rz = 10 μm ± 2 μm à 100 μm ± 20 μm.

4. Chambre de revêtement selon l'une quelconque des revendications précédentes, la première surface de rayonnement (311) présentant une surface noire et/ou un revêtement de surface (30) avec un premier coefficient d'échange thermique élevé (εD1) dans la plage de 0.1 à 1.0, en particulier entre 0.5 et 0.95, de manière particulièrement préférée entre 0.7 et 0.9, en particulier un premier coefficient d'échange thermique (εD1) dans la plage d'environ 0.85 par rapport au coefficient d'échange thermique noir (εSch) de corps noir avec εSch = 1.0.

5. Chambre de revêtement selon l'une quelconque des revendications précédentes, la première surface de rayonnement (311) et/ou la deuxième surface de rayonnement (312) comprenant le revêtement de surface (30), et le revêtement de surface (30) comprenant en particulier un revêtement déposé par PVD, en particulier un revêtement AlxTiyN, de préférence Al66Ti33N et/ou un revêtement AlCrN, en particulier un revêtement Al66Cr33N, et/ou un revêtement DLC approprié, en particulier un revêtement a-C, a-C:H, a-C.H:X, a-C:H:Me, le revêtement étant de préférence un revêtement déposé de manière optiquement dense et/ou présentant une épaisseur de couche de 100 nm à quelques 1000 nm, en particulier entre 300 nm et 800 nm et de manière particulièrement préférée d'au moins 500 nm.

6. Chambre de revêtement selon la revendication 5, le bouclier thermique (3, 31, 32, 33) comprenant seulement exactement un bouclier de rayonnement (31) revêtu seulement sur la première surface de rayonnement (311), en particulier pour l'utilisation pour des revêtements à basse température dans la plage allant jusqu'à une température partielle maximale de 250 °C.

7. Chambre de revêtement selon l'une quelconque des revendications précédentes, entre le bouclier de rayonnement (31) directement adjacent à la paroi de chambre (2) et le bouclier de protection (32), de préférence un ou une pluralité d'autres boucliers rayonnants (33), en particulier jusqu'à trois boucliers rayonnants (33) étant prévus entre le bouclier de rayonnement (31) et le bouclier de protection (32).

8. Chambre de revêtement selon l'une quelconque des revendications précédentes, le bouclier de rayonnement (31) et/ou le bouclier de protection (32) et/ou le bouclier rayonnant (33) comprenant respectivement une zone de montage et étant fixés dans la zone de montage sur un dispositif de maintien (41) d'un support de bouclier (4), de préférence au moyen d'un seul et même support de bouclier (4) sur la paroi de chambre (2).

9. Chambre de revêtement selon l'une quelconque des revendications précédentes, le bouclier de rayonnement (31) et/ou le bouclier de protection (32) et/ou le bouclier rayonnant (33) étant réalisés géométriquement de manière identique au moins dans la zone de montage de telle sorte qu'ils puissent être utilisés de manière interchangeable dans chaque dispositif de maintien (41) du support de bouclier (4), de sorte que différentes caractéristiques de l'échange de chaleur puissent être ajustées de manière flexible entre la paroi de chambre (2) et le bouclier thermique (3, 31, 32, 33) et/ou le bouclier de rayonnement (31) et/ou le bouclier de protection (32) et/ou le bouclier rayonnant (33) étant connectés de manière électriquement isolée à la paroi de chambre (2).

10. Chambre de revêtement selon l'une quelconque des revendications précédentes, la chambre de revêtement comprenant une paroi de chambre (2) réalisée à double paroi, de sorte qu'un fluide de régulation de température (5), en particulier de l'eau ou une huile, puisse circuler à l'intérieur de la paroi de chambre (2) à double paroi pour la régulation de température de celle-ci.

11. Chambre de revêtement selon l'une quelconque des revendications précédentes, le côté intérieur (21) de la paroi de chambre (2) présentant une rugosité dans la plage de Ra = 1 $\mu$m $\pm$ 0.2 $\mu$m à 10 $\mu$m $\pm$ 2 $\mu$m et/ou de Rz = 10 $\mu$m $\pm$ 2 $\mu$m à 100 $\mu$m $\pm$ 20 $\mu$m et/ou le côté intérieur (21) présentant une couche noire avec un coefficient d'échange thermique élevé ($\varepsilon$K) dans la plage de 0.1 à 1.0, en particulier entre 0.2 et 0.8, de manière particulièrement préférée entre 0.3 et 0.6, en particulier un coefficient d'échange de chambre ($\varepsilon$K) dans la plage d'environ 0.4 par rapport au coefficient d'échange thermique noir de corps noir avec ESch = 1.0.

12. Chambre de revêtement selon l'une quelconque des revendications précédentes, le côté intérieur (21) de la paroi de chambre (2) comprenant un revêtement de chambre, et le revêtement de chambre (20) comprenant en particulier un revêtement déposé par PVD, en particulier un revêtement AlxTiyN, de préférence Al66Ti33N et/ou un revêtement AlCrN, en particulier un revêtement Al66Cr33N, et/ou un revêtement DLC approprié, en particulier un revêtement de chambre (20) a-C, a-C:H, a-C.H:X, a-C:H:Me, le revêtement de chambre (20) étant de préférence un revêtement déposé de manière optiquement dense et/ou présentant une épaisseur de couche de 100 nm à quelques 1000 nm, en particulier entre 300 nm et 800 nm et de manière particulièrement préférée d'au moins 500 nm.

13. Procédé de revêtement utilisant une chambre de revêtement (1) selon l'une quelconque des revendications 1 à 12, le procédé de revêtement étant un procédé PVD, en particulier un procédé PVD comprenant une pulvérisation magnétron et/ou HIPIMS, ou un procédé CVD assisté par plasma ou un procédé d'évaporation à l'arc sous vide cathodique ou anodique ou un procédé combiné formé à partir de ces procédés ou un autre procédé de revêtement assisté par vide.

14. Procédé de revêtement selon la revendication 13, le procédé de revêtement étant un procédé de revêtement à basse température et la chambre de revêtement (2) étant tempérée avec un fluide de régulation de température (5), en particulier de l'eau ou une huile, à une température dans la plage de 10 °C à 30 °C, ou le procédé de revêtement étant un procédé de revêtement à haute température et la chambre de revêtement (2) étant tempérée avec le fluide de régulation de température, en particulier de l'eau ou de l'huile, à une température dans la plage de 40 °C à 60 °C.

Fig.1

Fig.2

Fig.3

**300**  **200**

**100**

**150**

**310**  **210**

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6046439 A

- JP 2015000994 A